# EUROPÄISCHE PATENTANMELDUNG

(11) **EP 0 902 480 A2**
(43) Veröffentlichungstag der Anmeldung: **17.03.1999**
(21) Anmeldenummer: 98810771.0
(22) Anmeldetag: 11.08.1998
(51) Int. Cl.: H01L 29/747

(54) **Bidirektionales Leistungshalbleiterbauelement**

(30) Priorität: 09.09.1997 DE 19739381
(71) Anmelder: Asea Brown Boveri AG, 5401 Baden (CH)
(72) Erfinder: Ramezani, Ezatollah, Dr., 5103 Möriken (CH); Waldmeyer, Jürg, Dr., 5605 Dottikon (CH)
(74) Vertreter: Weibel, Beat

(57) **Zusammenfassung**

Ein bidirektional leitendes und sperrendes Leistungshalbleiterbauelement wird dadurch gebildet, dass ein erster und zweiter Thyristor in entgegengesetzter Polung in Serie geschaltet sind und antiparallel zu den Thyristoren je eine Diode vorgesehen ist. Die beiden Gates sind miteinander verbunden und bilden einen gemeinsamen Steueranschluss. Das auf diese Weise gebildete Bauelement kann in einem gemeinsamen Gehäuse integriert werden.

## Beschreibung

### Technisches Gebiet

Die Erfindung bezieht sich auf das Gebiet der Leistungselektronik. Sie geht aus von einem bidirektionalen Leistungshalbleiterbauelement nach dem Oberbegriff des ersten Anspruchs.

### Stand der Technik

Um das Ziel "idealer Schalter" verwirklichen zu können, wäre es wünschenswert einen bidirektional leitenden und sperrenden Leistungshalbleiterschalter zur Verfügung zu haben, der in einem einzigen Gehäuse untergebracht ist, nur einen Steueranschluss aufweist und somit von aussen als einheitliches Bauelement angesehen werden kann.

Grundsätzlich lassen sich bidirektionale Leistungshalbleiterbauelemente auf zwei Arten herstellen: Einerseits können zwei antiparallel geschaltete Thyristoren in einem gemeinsamen Gehäuse oder sogar auf einer gemeinsamen Halbleiterscheibe untergebracht werden. Dieser Ansatz wurde in der Deutschen Offenlegungsschrift DE 44 39 012 verfolgt. Nachteilig an dieser Lösung ist jedoch, dass zwei getrennte Steueranschlüsse und damit zwei voneinander unabhängige Ansteuereinheiten erforderlich sind. Ausserdem besteht keine Möglichkeit, die Betriebsparameter der Bestandteile gezielt und unabhängig voneinander zu optimieren.

Andererseits ist mit dem Triac seit langem ein bidirektional leitender und sperrender Thyristor mit einem einzigen Steueranschluss bekannt. Sein Einsatzbereich ist aber aufgrund physikalischer Grenzen dadurch begrenzt, dass keine hohe Blockierfähigkeit (die Grenze liegt ca. bei 1 kV) und auch keine hohe Stromtragfähigkeit (maximal ca. 10 A) erzielt werden können. Für Hochleistungsanwendungen ist der Triac demzufolge nicht geeignet. Seine grundlegenden Eigenschaften, d.h. bidirektionale Leit- und Sperrfähigkeit sowie nur ein Steueranschluss, wären aber z.B. für die Konstruktion eines sehr kompakten, netzgeführten Stromrichters insbesondere im Hinblick auf Kühlung und das Einspannsystem von grossem Interesse.

### Darstellung der Erfindung

Aufgabe der Erfindung ist es deshalb, ein bidirektionales Leistungshalbleiterbauelement anzugeben, das für höchste Leistungen eingesetzt werden kann. Ausserdem soll es nur einen Steueranschluss aufweisen. Diese Aufgabe wird durch die Merkmale des unabhängigen Anspruchs 1 gelöst.

Kern der Erfindung ist es also, dass ein erster und zweiter Thyristor in entgegengesetzter Polung in Serie geschaltet sind und antiparallel zu den Thyristoren je eine Diode vorgesehen ist. Die beiden Gates sind miteinander verbunden und bilden einen gemeinsamen Steueranschluss. Auf diese Weise erhält man ein bidirektional leitendes und sperrendes Bauelement, das in einem gemeinsamen Gehäuse integriert werden kann.

Die Thyristoren und die Dioden können einzeln optimiert werden. Besonders bevorzugt wird eine Lösung, bei der die Thyristoren eine asymmetrische Sperrcharakteristik aufweisen. Ausserdem können Thyristoren und Dioden eine Stopschicht aufweisen und auf einer gemeinsamen Halbleiterscheibe integriert werden. Die beiden Halbleiterscheiben können in einem Druckkontaktgehäuse untergebracht werden.

Weitere vorteilhafte Ausführungsformen ergeben sich aus den entsprechenden abhängigen Ansprüchen.

Ein wesentlicher Vorteil der Erfindung ist, dass das Leistungshalbleiterbauelement im Gegensatz zum Triac für höchste Leistungen eingesetzt werden kann und dass die Parameter im Gegensatz zum eingangs genannten bidirektional leitenden Bauelement einzeln eingestellt werden können. Mit Hilfe des erfindungsgemässen Leistungshalbleiterbauelements wird es möglich, äusserst kompakte Stromrichter aufzubauen, bei denen der Aufwand insbesondere für die Kühlung und für das Einspannsystem drastisch reduziert werden können.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine Ersatzschaltung des erfindungsgemässen Leistungshalbleiterbauelements;
- **Fig. 2**: Eine Aufsicht auf einen im Rahmen der Erfindung verwendbaren Thyristor mit integrierte Diode;
- **Fig. 3**: Ein erfindungsgemässes Leistungshalbleiterbauelement in einem Gehäuse nach einer ersten Variante;
- **Fig. 4**: Ein erfindungsgemässes Leistungshalbleiterbauelement in einem Gehäuse nach einer zweiten Variante.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

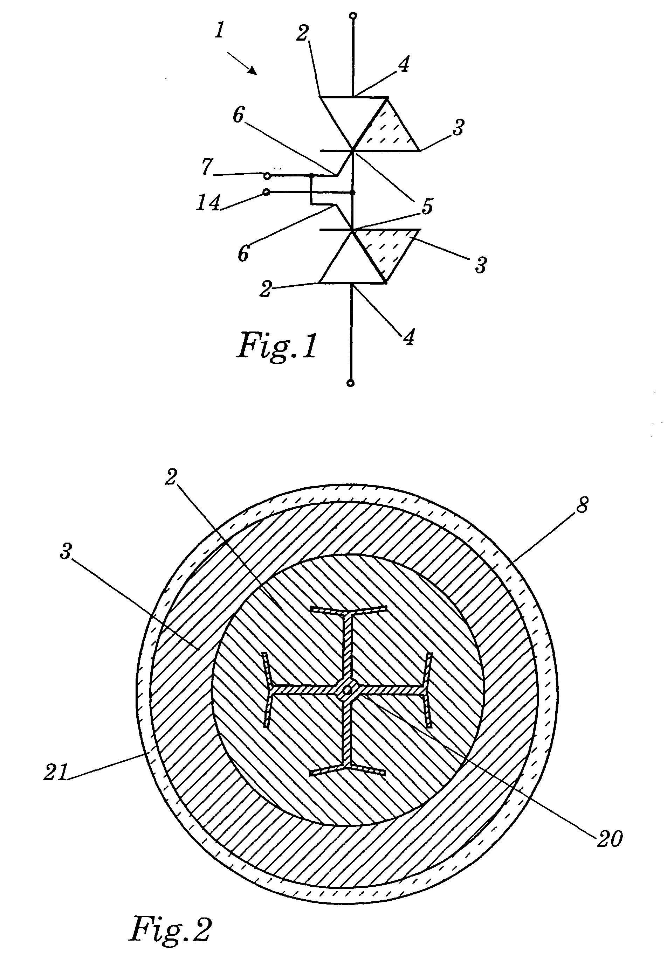

Figur 1 zeigt eine Ersatzschaltung eines erfindungsgemässen Leistungshalbleiterbauelements 1. Zwei Thyristoren 2 sind in entgegengesetzter Polung in Serie geschaltet, so dass die beiden Kathoden 5 miteinander verbunden sind. Antiparallel zu den Thyristoren 2 sind jeweils Dioden 3 vorgesehen. Die Gates 6 der Thyristoren 2 sind ebenfalls miteinander verbunden und bilden einen gemeinsamen Steueranschluss 7. Die verbundenen Kathoden 5 bilden ausserdem einem Hilfskathodenanschluss 14.

Das Bauelement funktioniert wie folgt: Werden die beiden Thyristoren mit Hilfe eines entsprechenden Steuersignals am Steueranschluss in den leitenden Zustand versetzt, so leitet der obere Thyristor und die untere Diode den Strom im Falle eines in Figur 1 von oben nach unten fliessenden Stromes. Im Falle eines von unten nach oben fliessenden Stromes wird die Stromführung durch den unteren Thyristor und die obere Diode übernommen. Werden die beiden Thyristoren 2 nach der Kommutierung des Stromes sowie durch Entfernen des Steuerstromes am gemeinsamen Steueranschluss 7 in den sperrenden Zustand gebracht, so sperren beide Thyristoren, und da die beiden Dioden entgegengesetzt geschaltet sind, fliesst kein Strom.

Wie Figur 2 zeigt, werden die Thyristoren 2 und die zugeordneten Dioden 3 vorzugsweise in einer gemeinsamen Halbleiterscheibe 8 untergebracht. Die Thyristoren 2 weisen mit Vorteil eine asymmetrische Sperrcharakteristik auf, d.h. sie weisen nur einen hochsperrenden PN-Uebergang auf. Mit der erfindungsgemässen Anordnung kann aber trotzdem ein bidirektional leitendes und sperrendes Bauteil aufgebaut werden, da der zweite hochsperrende PN-Übergang vom zweiten Thyristor zur Verfügung gestellt wird. Auf der Halbleiterscheibe umgibt die Diode 3 den Thyristor 2, dessen Gatefinger 20 sehr gut ersichtlich sind, konzentrisch. Dies hat insbesondere den Vorteil, dass die Einschaltverluste herabgesetzt werden. Die Scheibe 8 wird randseitig von einem Randabschlussgebiet 21 abgeschlossen.

Nach der Erfindung werden Diode 3 und Thyristor 2 bevorzugt mit einer Stopschicht ausgerüstet. Sie erlaubt es, die Dicke der Halbleiterscheibe 8 bei gleichbleibender Sperrfähigkeit zu reduzieren. Beim Thyristor ist die Sperrschicht im Anodenemitter angeordnet, bei der Diode im Kathodengebiet. Ausserdem kann die Freiwerdezeit des Bauelements durch Einstellen der Trägerlebensdauer in den Thyristoren 2 und seine Trägerstauladung durch Einstellen der Trägerlebensdauer in den Dioden 3 gesondert optimiert werden. Diese Möglichkeit der gezielten Optimierung der Betriebsparameter stellt einen wesentlichen Vorteil des erfindungsgemässen Bauteils dar. Insbesondere bei Triacs oder bei dem eingangs erwähnten bidirektional leitenden Thyristor ist dies nur mit enormen Aufwand möglich. Auf die erfindungsgemässe Weise kann das Bauelement anwendungsspezifisch optimiert werden. Der Trade-Off zwischen Durchlassverlusten und Schaltverlusten kann verglichen mit einem Einzelelement verbessert werden. Dies erlaubt insbesondere auch eine Verkleinerung der eventuell benötigten Schutzbeschaltung.

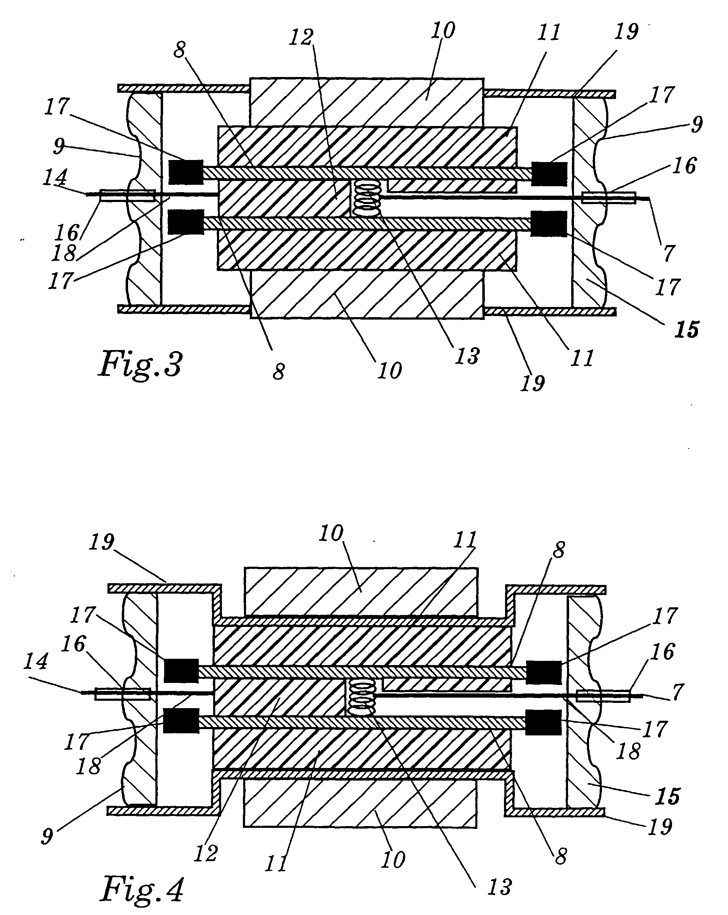

Besonders geeignet ist das erfindungsgemässe Bauteil auch für die Unterbringung der beiden Halbleiterscheiben in einem gemeinsamen Gehäuse. Die Figuren 3 und 4 zeigen entsprechende Beispiele mit Druckkontaktgehäusen. Das Gehäuse 9 weist zwei Druckstempel 10 auf, die über Kontaktscheiben 11 die Halbleiterscheiben 8 kontaktieren. Zwischen den Halbleiterscheiben 18 ist ein Kontaktring 12 vorgesehen, der die Kathoden der Thyristoren bzw. die Anoden der Dioden verbindet. In der zentralen Aussparung des Kontaktringes 12 ist ein Kontaktsystem 13 vorgesehen, im einfachsten Fall eine Feder, das die beiden zentralen Gates der Thyristoren zum gemeinsamen Steueranschluss 7 verbindet. In dem Kontaktring 12 ist ausserdem eine Einfräsung vorgesehen, durch welche ein mit dem Kontaktsystem 13 verbundener Anschlussdraht 18 isoliert nach aussen geführt wird. Der Kontaktring 12 ist ausserdem mit einem Anschlussdraht 18 verbunden, der den Hilfskathodenanschluss 14 bildet. Das Gehäuse 9 wird durch ringförmige Isolatoren 15, z.B. aus Keramik und oben und unten durch Kontaktflansche 19 hermetisch abgeschlossen. In den Isolatoren 15 sind Durchführungen 16 für die Anschlussdrähte 18 des Steueranschlusses 7 und des Hilfskathodenanschlusses 14 vorgesehen. Die Kontaktscheiben 11 und der Kontaktring 12 bestehen vorzugsweise aus Molybdän, die Druckstempel 10 aus Kupfer. Die Halbleiterscheiben 8 sind am Rand mit einer Randpassivierung 17 insbesondere aus einem organischen oder anorganischen Material versehen.

Das Ausführungsbeispiel nach Figur 4 unterscheidet sich von demjenigen nach Figur 3 dadurch, dass die Kontaktflansche 19 gebogen und zwischen die Druckstempel 10 und die Kontaktscheiben 11 gefügt sind.

Die Erfindung ist nicht nur auf die Verwendung von klassischen Thyristoren beschränkt. Ebenso können abschaltbare Thyristoren oder IGBTs verwendet werden. Die Thyristoren können auch mit Licht angesteuert werden. Insgesamt erlaubt das erfindungsgemässe Bauelement eine hohe Spannungstragfähigkeit bis zu 12 kV mit vertretbaren Durchlassverlusten. Gleichzeitig kann eine hohe Stromtragfähigkeit erreicht werden. Die dynamischen Eigenschaften sind verglichen mit Thyristoren hervorragend. Ausserdem erlaubt die Bildung des gemeinsamen Steueranschlusses die Einsparung einer Ansteuerschaltung.

### Bezugszeichenliste

- 1: Leistungshalbleiterbauelement
- 2: Thyristor
- 3: Diode
- 4: Anode
- 5: Kathode
- 6: Gate
- 7: Steueranschluss
- 8: Halbleiterscheibe
- 9: Gehäuse
- 10: Druckstempel
- 11: Kontaktscheibe
- 12: Kontaktring
- 13: Kontaktsystem
- 14: Hilfskathodenanschluss
- 15: Isolator
- 16: Durchführung
- 17: Randpassivierung
- 18: Anschlussdraht
- 19: Kontaktflansch
- 20: Gatefinger
- 21: Randabschlussgebiet

## Patentansprüche

1. Bidirektionales Leistungshalbleiterbauelement (1) umfassend mindestens einen ersten und einen zweiten Thyristor (2) mit je einer Kathode (5), einer Anode (4) und einem Gate (6) dadurch gekennzeichnet, dass die Thyristoren (2) in entgegengesetzter Polung in Serie geschaltet sind, so dass die Kathoden (5) der Thyristoren verbunden sind, und dass antiparallel zu den Thyristoren je eine Diode (3) vorgesehen ist sowie dass die Gates (6) der Thyristoren elektrisch miteinander verbunden sind und einen gemeinsamen Steueranschluss (7) bilden.

2. Bauelement nach Anspruch 1, dadurch gekennzeichnet, dass die miteinander verbunden Kathoden (5) der Thyristoren einen Hilfskathodenanschluss (14) bilden.

3. Bauelement nach Anspruch 1 oder 2, dadurch gekennzeichnet, dass die Thyristoren eine asymmetrische Sperrcharakteristik aufweisen.

4. Bauelement nach einem der vorstehenden Ansprüche, dadurch gekennzeichnet, dass die Thyristoren im Bereich des Anodenemitters und die Dioden im Bereich ihrer Kathoden eine Stopschicht aufweisen.

5. Bauelement nach einem der vorstehenden Ansprüche, dadurch gekennzeichnet, dass jeder der Thyristoren und die zugehörige antiparallele Diode in einer eigenen, Thyristor und Diode umfassenden Halbleiterscheibe (8) ausgebildet sind, wobei die Dioden (3) den jeweiligen Thyristor (2) zentrisch umgeben.

6. Bauelement nach Anspruch 5, dadurch gekennzeichnet, dass die Halbleiterscheiben (8) in einem gemeinsamen Gehäuse (9) untergebracht sind.

7. Bauelement nach Anspruch 6, dadurch gekennzeichnet, dass das Gehäuse (9) ein Druckkontaktgehäuse ist, in welchem Druckstempel (10) Kontaktscheiben (11) auf die Halbleiterscheiben (8) pressen, wobei die beiden Halbleiterscheiben unter Zwischenfügung eines Kontaktringes (12) und eines die beiden Gates elektrisch verbindenden Kontaktsystems (13) aufeinander gestapelt sind.
